# EUROPEAN PATENT APPLICATION

(11) **EP 3 822 390 A1**
(43) Date of publication of application: **19.05.2021**
(21) Application number: 19861362.2
(22) Date of filing: 18.09.2019
(51) Int. Cl.: C23C 16/455, C23C 16/04, C23C 16/54

(54) **APPARATUS FOR DEPOSITING ATOMIC LAYER**

(30) Priority: 20.09.2018 KR 20180112849
(71) Applicant: LG Chem, Ltd., Seoul 07336, (KR)
(72) Inventor: PARK, Sang Joon, Daejeon 34122 (KR); KIM, Ki Hwan, Daejeon 34122 (KR); LEE, Eun Jeong, Daejeon 34122 (KR)
(74) Representative: Plasseraud IP
(86) International application number: PCT/KR2019/012055
(87) International publication number: WO 2020/060182

(57) **Abstract**

The present invention relates to an atomic layer deposition apparatus, and according to one aspect of the present invention, it can reduce a gas consumption while sufficiently securing a gas exposure time upon traveling a substrate through a roll-to-roll process.

## Description

### Technical Field

The present invention relates to an atomic layer deposition apparatus.

This application claims the benefit of priority based on Korean Patent Application No. 10-2018-0112849 filed on September 20, 2018, the disclosure of which is incorporated herein by reference in its entirety.

### Background Art

As a method of forming a film on a substrate, there is, for example, an atomic layer deposition method.

The atomic layer deposition (ALD) is typically a technique for forming a film on a substrate based on sequential supply of gas phase chemicals, which has been applied to various fields.

In a roll-to-roll atomic layer deposition method, the supply type of a precursor gas and a purge gas may be divided into a nozzle method and a region division method.

The nozzle method is a type in which the precursor gas and the purge gas are supplied through nozzles which are regularly repeated and arranged in a space.

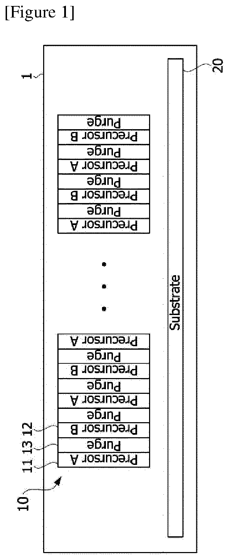

Figure 1 is a schematic view showing a nozzle type atomic layer deposition apparatus (1).

Referring to Figure 1, the atomic layer deposition apparatus (1) comprises a nozzle (10) having a plurality of supply ports (11, 12, 13) and a transfer device for transferring a substrate (20). The nozzle (10) has precursor gas supply ports (11, 12) for supplying one or more precursor gases (precursor A, B) and purge gas supply ports (13) for supplying a purge gas such as an inert gas.

Although the nozzle method has a small gas consumption, there is a disadvantage that the gas exposure time is insufficient when the traveling speed of the substrate is increased.

Alternatively, the region division method is a method of dividing the atomic layer deposition apparatus into a precursor gas space and a purge gas space, and then filling each entire space with the precursor gas and the purge gas. The region division method can secure a sufficient gas exposure time according to the region width, but has a disadvantage of a large gas consumption.

Therefore, there is a need to develop an atomic layer deposition apparatus capable of reducing the gas consumption while securing the sufficient gas exposure time.

### Disclosure

### Technical Problem

It is a problem solved by the present invention to provide an atomic layer deposition apparatus capable of reducing a gas consumption while sufficiently securing a gas exposure time.

### Technical Solution

In order to solve the above-described problem, according to one aspect of the present invention, an atomic layer deposition apparatus is provided, which comprises a first precursor supply region where a first gas supply nozzle having a plurality of first precursor gas supply ports arranged in sequence along the traveling direction of a substrate so as to supply a first precursor gas on the substrate when the substrate travels, is disposed, a second precursor supply region provided so as to supply a second precursor gas on the substrate when the substrate travels, a purge gas supply region positioned between the first precursor supply region and the second precursor supply region, opened to each of the first precursor supply region and the second precursor supply region, and provided so as to supply a purge gas on the substrate when the substrate travels; and a roll unit provided with a plurality of guide rolls arranged such that the substrate passes through the purge gas supply region each time to traverse multiple times between the first precursor supply region and the second precursor supply region.

### Advantageous Effects

As described above, the atomic layer deposition apparatus related to at least one example of the present invention has the following effects.

Upon traveling a substrate through a roll-to-roll process, it is possible to reduce a gas consumption whiling sufficiently secure a gas exposure time.

### Description of Drawings

Figure 1 is a schematic view showing a nozzle type atomic layer deposition apparatus.
Figure 2 is a schematic view showing an atomic layer deposition apparatus related to one example of the present invention.
Figure 3 is a plan view of a first gas supply nozzle.
Figure 4 is a schematic view showing a pair of gas supply nozzles.
Figure 5 is a plan view of a substrate.

### Mode for Invention

Hereinafter, an atomic layer deposition apparatus according to one example of the present invention will be described in detail with reference to the accompanying drawings.

In addition, the same or similar reference numerals are given to the same or corresponding components regardless of reference numerals, of which redundant explanations will be omitted, and for convenience of explanation, the size and shape of each constituent member as shown may be exaggerated or reduced.

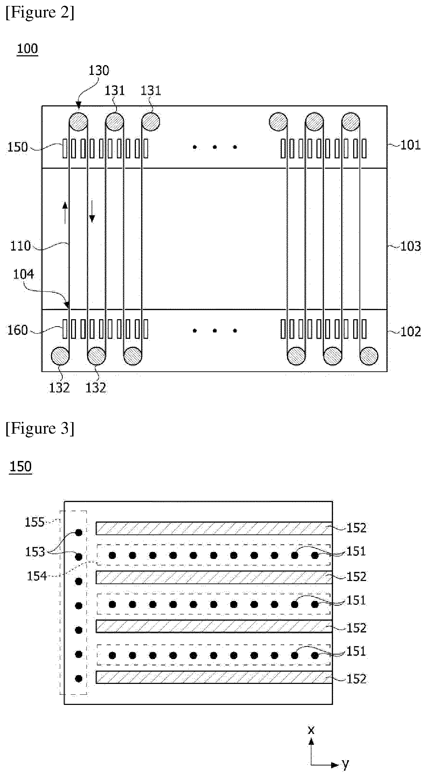

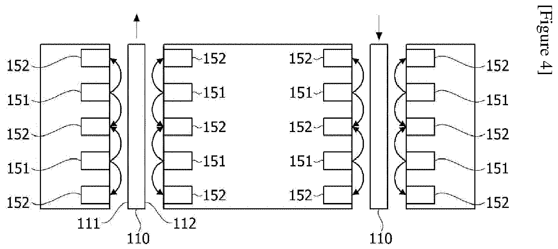

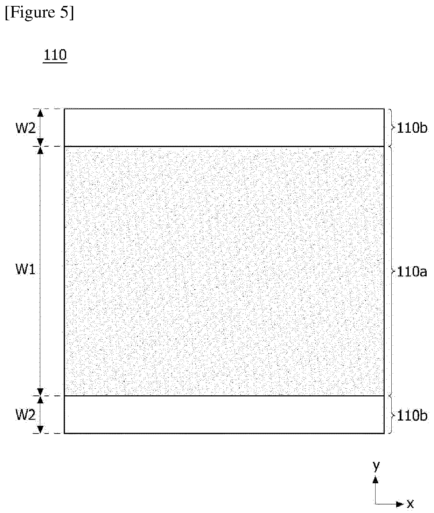

Figure 2 is a schematic view showing an atomic layer deposition apparatus (100) related to one example of the present invention, Figure 3 is a plan view of a first gas supply nozzle, Figure 4 is a schematic view showing a pair of gas supply nozzles, and Figure 5 is a plan view of a substrate.

The atomic layer deposition apparatus (100) comprises a first precursor supply region (101), a second precursor supply region (102) and a purge gas supply region (103).

The atomic layer deposition apparatus (100) related to one example of the present invention is a roll-to-roll atomic layer deposition apparatus (100). Particularly, it is an atomic layer deposition apparatus (100) that the first precursor supply region (101), the purge gas supply region (103) and the second precursor supply region (102) are divided. Specifically, the precursor supply method of at least one of the first precursor and the second precursor may be implemented by the nozzle method, and the purge gas supply method may be implemented in a state where the purge gas is filled in the purge gas supply region, as in a conventional space division atomic layer deposition apparatus.

Each of the supply regions (101, 102, 103) provides a treatment region where the precursor gas is deposited on the substrate (300) to form a film or the purge gas is supplied. In addition, each of the supply regions (101, 102, 103) is provided such that the process temperature and process pressure may be adjusted.

In the specification, one of the first precursor and the second precursor may be TMA (trimethyl-aluminum), and the other may be H₂O.

In addition, the substrate (110) is an electrode substrate, which may be, particularly, a positive electrode or a negative electrode of a lithium ion secondary battery for automobiles, and the substrate (110) may have a first surface (111) and a second surface (112) opposite to the first surface (111), wherein an electrode layer may be formed on each of the first surface (111) and the second surface (112). Furthermore, the substrate (110) may be a substrate formed of a flexible material so that it can also cope with a direction change section as well as a straight section when traveling along the guide roll.

Also, the atomic layer deposition apparatus (100) of the present invention may have a structure capable of simultaneous deposition on both sides so as to form a film on each electrode layer of the first surface (111) and the second surface (112) of the substrate (110).

Specifically, the atomic layer deposition apparatus (100) comprises the first precursor supply region (101) where first supply nozzles (150) provided such that the first precursor gas is supplied on the substrate (110) when the substrate (110) travels, are disposed.

That is, one or more first gas supply nozzles (150) are disposed in the first precursor supply region (101) so that the first precursor is supplied by the nozzle method. At this time, the first gas supply nozzles (150) may be disposed in a linear travel section of the substrate (110) in the first precursor supply region. In addition, a plurality of first gas supply nozzles (150) may be disposed in the first precursor supply region (101) along the traveling direction of the substrate.

Particularly, a pair of first gas supply nozzles (150) provided such that the first precursor gas is supplied toward each of the first surface (111) of the substrate (110) and the second surface (112) opposite to the first surface (111) may be disposed in the first precursor supply region (101). Through such a structure, it is possible to simultaneously deposit both sides (first and second surfaces) under travel of the substrate.

In addition, the first gas supply nozzles (150) may be provided such that the interval from the substrate is adjustable.

Also, the atomic layer deposition apparatus (100) comprises the second precursor supply region (103) provided such that the second precursor gas is supplied on the substrate (110) when the substrate (110) travels.

The second precursor supply region (102) may be provided such that the corresponding region is filled with the second precursor gas, as in the conventional space division method. Alternatively, second gas supply nozzles (160) provided such that the second precursor gas is supplied on the substrate (110) may be disposed in the second precursor supply region (102).

At this time, the second gas supply nozzles (160) may be disposed in a linear travel section of the substrate (110) in the second precursor supply region. In addition, a plurality of second gas supply nozzles (160) may be disposed in the second precursor supply region (102) along the traveling direction of the substrate. Particularly, a pair of second gas supply nozzles (160) provided such that the second precursor gas is supplied toward each of the first surface (111) of the substrate (110) and the second surface (112) opposite to the first surface (111) may be disposed in the second precursor supply region (102). Through such a structure, it is possible to simultaneously deposit both sides (first and second surfaces) under travel of the substrate.

Also, the atomic layer deposition apparatus (100) comprises the purge gas supply region (103) positioned between the first precursor supply region (101) and the second precursor supply region (102), opened to each of the first precursor supply region (101) and the second precursor supply region (102), and provided so as to supply a purge gas on the substrate when the substrate (110) travels.

The purge gas supply region (103) is provided with a plurality of slits (104), through which the substrate (110) can pass, so as to be opened to each of the first precursor supply region (101) and the second precursor supply region (102).

In addition, the atomic layer deposition apparatus (100) comprises the roll unit (130) provided with a plurality of guide rolls (131, 132) arranged such that the substrate passes through the purge gas supply region (103) each time to traverse multiple times between the first precursor supply region (101) and the second precursor supply region (102).

In the roll unit (130), the guide roll arranged in the first precursor supply region (101) is referred to as a first guide roll (131), and the guide roll arranged in the second precursor supply region (102) is referred to as a second guide roll (132).

Through such a structure, the substrate (110) travels through the first precursor supply region (101), the purge gas supply region (130) and the second precursor supply region (102), and then travels through the purge gas supply region (130) and the first precursor supply region (101).

In Figures 3 and 5, the x-axis direction represents the traveling direction of the substrate (110), and the y-axis direction represents the width direction of the substrate (110).

Referring to Figures 3 and 4, the first gas supply nozzle (150) may have a plurality of first precursor gas supply ports (154, for example, H₂O supply ports) arranged in sequence along the traveling direction of the substrate (110) and first and second gas curtain ports (155) located on both sides based on the traveling direction of the substrate (only the first gas curtain port is shown on the left side in Figure 3). The first precursor gas supply port (154) comprises a plurality of first precursor gas supply holes (151) arranged along the width direction of the substrate.

The first and second gas curtain ports perform a function of forming boundaries of the gas supply regions such that the first precursor gas non-deposited regions (110b) are each generated along the traveling direction on both sides based on the traveling direction of the substrate (110). Each gas curtain port may have a plurality of gas injection holes (153). The gas injection holes (153) may be arranged along the traveling direction of the substrate, where an inert gas (for example, N2) may be injected through the gas injection holes (153).

Furthermore, in the first gas supply nozzle, vacuum ports (152) are provided between two adjacent first precursor gas supply ports (154).

The first precursor gas supply ports (154) are connected to a corresponding precursor gas supply source and provided so as to inject the first precursor gas toward the substrate (110), whereby a film is formed on the substrate (110). At this time, for convenience of description, the region where the first precursor gas is applied on the substrate (110) through the first precursor gas supply ports (154) may be referred herein to as a 'gas supply region.'

Meanwhile, the first and second gas curtain ports (155) are positioned on both sides based on the traveling direction (x-axis direction) of the substrate (110), that is, at both edges in the width direction of the first gas supply nozzle (150), respectively. Each gas curtain port (155) is connected to a supply source of an inert gas (for example, N₂), where the inert gas is injected toward the substrate (110) through the gas curtain ports (155). At this time, each gas curtain port (155) may have a channel shape extending along the traveling direction of the substrate. For example, each gas curtain port (155) may be arranged in an orthogonal state with the precursor gas supply port (154).

In the present invention, the first and second gas curtain ports (155) form boundaries of the gas supply regions such that the precursor gas non-deposited regions (110b) are each generated along the traveling direction on both sides (both edges in the width direction) based on the traveling direction of the substrate (110). That is, the first and second gas curtain ports (155) are provided so as to inject the inert gas to both edges in the width direction of the substrate (110).

Specifically, when the first precursor gas is injected through the first precursor gas supply port (154), the inert gas is injected through the first and second gas curtain ports (155). At this time, the precursor gas injected onto the substrate (110) through the first precursor gas supply port (154) is not applied to both edges in the width direction of the substrate (110) by the inert gas injected from the first and second gas curtain ports (155). Accordingly, the substrate (110) is divided into the deposited region (110a) in the central portion and the non-deposited region (110b) at both edges in the width direction (see Figure 5).

In addition, the first and second gas curtain ports (155) may be provided so as to form boundaries of the gas supply regions with respect to the plurality of first precursor gas supply ports (154). Alternatively, the first and second gas curtain ports (155) may also be provided so as to form boundaries of the gas supply regions with respect to some of the plurality of first precursor gas supply ports (154).

For example, the non-deposited region (110b) of the substrate (110) may have a width (w2) of 0.5mm to 20mm.

Furthermore, the traveling speed of the substrate may be 0.5 to 50m/min, and for example, the deposition speed at a traveling speed of 12m/min may be 5.3nm/min.

The second gas supply nozzle (160) has the same structure as that of the first gas supply nozzle. Briefly, it has a plurality of second precursor gas supply ports arranged in sequence along the traveling direction of the substrate and first and second gas curtain ports located on both sides based on the traveling direction of the substrate.

In addition, the first and second gas curtain ports form boundaries of the gas supply regions such that the second precursor gas non-deposited regions are each generated along the traveling direction on both sides based on the traveling direction of the substrate.

Furthermore, the vacuum ports are provided between two adjacent precursor gas supply ports.

The preferred examples of the present invention as described above are disclosed for illustrative purposes, which can be modified, changed and added within thought and scope of the present invention by those skilled in the art and it will be considered that such modification, change and addition fall within the following claims.

### Industrial Applicability

The atomic layer deposition apparatus related to at least one example of the present invention can reduce a gas consumption while sufficiently securing a gas exposure time upon traveling a substrate through a roll-to-roll process.

## Claims

1. An atomic layer deposition apparatus comprising: a first precursor supply region where a first gas supply nozzle having a plurality of first precursor gas supply ports arranged in sequence along the traveling direction of a substrate so as to supply a first precursor gas on the substrate when the substrate travels, is disposed;
a second precursor supply region provided so as to supply a second precursor gas on the substrate when the substrate travels;
a purge gas supply region positioned between the first precursor supply region and the second precursor supply region, opened to each of the first precursor supply region and the second precursor supply region, and provided so as to supply a purge gas on the substrate when the substrate travels; and
a roll unit provided with a plurality of guide rolls arranged such that the substrate passes through the purge gas supply region each time to traverse multiple times between the first precursor supply region and the second precursor supply region.

2. The atomic layer deposition apparatus according to claim 1,
wherein a pair of first gas supply nozzles provided such that the first precursor gas is supplied toward each of the first surface of the substrate and the second surface opposite to the first surface is disposed in the first precursor supply region.

3. The atomic layer deposition apparatus according to claim 2,
wherein the first gas supply nozzle has first and second gas curtain ports located on both sides based on the traveling direction of the substrate.

4. The atomic layer deposition apparatus according to claim 3,
wherein the first and second gas curtain ports form boundaries of the gas supply regions such that precursor gas non-deposited regions are each generated along the traveling direction on both sides based on the traveling direction of the substrate.

5. The atomic layer deposition apparatus according to claim 1,
wherein vacuum ports are provided between two adjacent first precursor gas supply ports.

6. The atomic layer deposition apparatus according to claim 4,
wherein the non-deposited region has a width of 0.5mm to 20mm.

7. The atomic layer deposition apparatus according to claim 1,
wherein the first gas supply nozzle is disposed in a linear travel section of the substrate in the first precursor supply region.

8. The atomic layer deposition apparatus according to claim 1,
wherein the first gas supply nozzle is provided such that the interval from the substrate is adjustable.

9. The atomic layer deposition apparatus according to claim 1,
wherein the second precursor supply region is provided such that the corresponding region is filled with the second precursor gas.

10. The atomic layer deposition apparatus according to claim 1,
wherein a second gas supply nozzle provided so as to supply the second precursor gas on the substrate is disposed in the second precursor supply region.

11. The atomic layer deposition apparatus according to claim 10,
wherein a pair of second gas supply nozzles provided such that the second precursor gas is supplied toward each of the first surface of the substrate and the second surface opposite to the first surface is disposed in the second precursor supply region.

12. The atomic layer deposition apparatus according to claim 10,
wherein the second gas supply nozzle has a plurality of second precursor gas supply ports arranged in sequence along the traveling direction of the substrate and first and second gas curtain ports located on both sides based on the traveling direction of the substrate.

13. The atomic layer deposition apparatus according to claim 12,
wherein the first and second gas curtain ports form boundaries of the gas supply regions such that the second precursor gas non-deposited regions are each generated along the traveling direction on both sides based on the traveling direction of the substrate.

14. The atomic layer deposition apparatus according to claim 12,
wherein vacuum ports are provided between two adjacent precursor gas supply ports.
